# EUROPÄISCHE PATENTSCHRIFT

(11) **EP 3 113 984 B1**
(45) Veröffentlichungstag und Bekanntmachung des Hinweises auf die Patenterteilung: **13.01.2021**
(21) Anmeldenummer: 15707951.8
(22) Anmeldetag: 05.03.2015
(51) Int. Cl.: B60R 16/03, H02J 1/00

(54) **STEUERGERÄT FÜR EIN MEHRSPANNUNGSBORDNETZ EINES FAHRZEUGS**
CONTROLLER FOR A MULTI-VOLTAGE ON-BOARD POWER SUPPLY SYSTEM IN A VEHICLE
APPAREIL DE COMMANDE POUR SYSTÈME ÉLECTRIQUE MULTI-TENSION D'UN VÉHICULE AUTOMOBILE

(30) Priorität: 05.03.2014 DE 102014203968
(43) Veröffentlichungstag der Anmeldung: 11.01.2017
(73) Patentinhaber: Brose Fahrzeugteile SE & Co. Kommanditgesellschaft, Bamberg, 96052 Bamberg (DE)
(72) Erfinder: MIJAC, Anto, 96052 Bamberg (DE)
(74) Vertreter: Maikowski & Ninnemann Patentanwälte Partnerschaft mbB
(86) Internationale Anmeldenummer: PCT/EP2015/054574
(87) Internationale Veröffentlichungsnummer: WO 2015/132326

(56) Entgegenhaltungen:
- WO-A1-2008/010062
- WO-A1-2009/012843
- DE-A1-102007 014 383
- DE-A1-102013 207 084
- US-A- 5 796 175

## Beschreibung

Die vorliegende Erfindung betrifft ein Steuergerät für ein Mehrspannungsbordnetz eines Fahrzeuges gemäß dem Oberbegriff des Patentanspruchs 1 sowie ein Verfahren zum Betreiben eines Steuergeräts für ein Mehrspannungsbordnetz eines Fahrzeugs gemäß dem Oberbegriff des Patentanspruchs 12.

Mehrspannungsbordnetze werden gelegentlich in Fahrzeugen, wie PKWs, LKWs, Zügen und dergleichen installiert. Ein Mehrspannungsbordnetz umfasst in der Regel ein erstes Teilnetz, das bei der ersten Versorgungsspannung betrieben wird, und ein zweites Teilnetz, das bei der zweiten Versorgungsspannung betrieben wird. Bekannt sind in diesem Zusammenhang insbesondere das 12 V-Teilnetz sowie das 48 V-Teilnetz für PKWs.

Zum Steuern einer Komponente, beispielsweise einer Pumpe, die von einem der beiden Teilnetze oder von beiden Teilnetzen betrieben wird, ist üblicherweise ein Steuergerät vorgesehen, das ein erstes Steuermodul und ein zweites Steuermodul umfasst. Das erste Steuermodul ist üblicherweise für einen Betrieb bei der ersten Versorgungsspannung des Mehrspannungsbordnetzes ausgebildet und das zweite Steuermodul üblicherweise für einen Betrieb bei der zweiten Versorgungsspannung. Dazu ist das erste Steuermodul über einen ersten Versorgungspfad an einen ersten Versorgungspannungsanschluss des Steuergeräts und/oder an einen ersten Masseanschluss des Steuergeräts angeschlossen, um mit Strom bei der ersten Versorgungsspannung versorgt zu werden. Analoges gilt für das zweite Steuermodul, das über einen zweiten Versorgungspfad an einen zweiten Versorgungsspannungsanschluss des Steuergeräts und/oder an einen zweiten Masseanschluss des Steuergeräts angeschlossen ist, um mit Strom bei der zweiten Versorgungsspannung versorgt zu werden. In beiden Versorgungspfaden können Spannungswandler vorgesehen sein, sodass den Steuermodulen eine jeweils gewandelte Versorgungsspannung zugeführt wird.

Die beiden Steuermodule können über einen Steuersignalpfad aneinander gekoppelt sein, um Steuersignale miteinander auszutauschen

Problematisch bei einem gattungsgemäßen Steuergerät für ein Mehrspannungsbordnetz eines Fahrzeuges ist, dass innerhalb des Mehrspannungsbordnetzes, beispielsweise im besagten Steuersignalpfad, Ausgleichsströme auftreten können, die Einheiten des Mehrspannungsbordnetzes, insbesondere Einheiten des Steuergeräts beschädigen oder zerstören können. Darüber hinaus können bei ständig anliegender erster Versorgungsspannung und zweiter Versorgungsspannung Kriechströme entstehen, beispielsweise begünstigt durch elektrochemische Migration (Feuchtigkeit), die ebenfalls zu Beschädigungen im Mehrspannungsbordnetz, insbesondere im Steuergerät für das Mehrspannungsbordnetz, führen können.

Aus der US 5,796,175 ist eine Steuereinrichtung zur elektrischen Versorgung eines Fahrzeugmotors bekannt, bei der der Motor über einen Inverter mit einer elektrischen Versorgung mit vergleichsweise großer Spannung verbunden ist. In einem Versorgungspfad zwischen der elektrischen Versorgung und dem Inverter ist eine Schalteinrichtung angeordnet, die über eine durch eine elektrische Versorgung niedrigerer Spannung betriebene Steuerung gesteuert wird.

Es ist daher eine der vorliegenden Erfindung zugrundeliegende technische Aufgabe, einen zuverlässigeren Betrieb eines Mehrspannungsbordnetzes eines Fahrzeuges zu gewährleisten.

Gemäß einem ersten Aspekt der Erfindung wird diese Aufgabe gelöst durch ein Steuergerät mit den Merkmalen des Anspruchs 1. Die Aufgabe wird gemäß einem zweiten Aspekt der Erfindung ferner gelöst durch ein Verfahren zum Betreiben eines Steuergeräts für ein Mehrspannungsbordnetz eines Fahrzeugs mit den Merkmalen des Anspruchs 12. Merkmale vorteilhafter Weiterbildungen sind in den Unteransprüchen angegeben.

Bei dem Steuergerät des ersten Aspektes der vorliegenden Erfindung enthält der zweite Versorgungspfad ein Schaltungsmodul, das ausgebildet ist, den zweiten Versorgungspfad in Abhängigkeit von einem Ansteuersignal wahlweise zu sperren oder leitfähig zu schalten.

Ist der zweite Versorgungspfad gesperrt, wird das zweite Steuermodul nicht mit Strom versorgt. Über den zweiten Versorgungspfad fließt bei Sperrung durch das Schaltungsmodul kein Strom. An dem zweiten Steuermodul liegt die zweite Versorgungsspannung bei gesperrten zweitem Versorgungspfad bevorzugt nicht an. Dadurch wird vermieden, dass Kurzschlüsse, Leckströme oder ähnliche Fehler in dem Steuergerät entstehen. Darüber hinaus können Bauteile des Steuergeräts kleiner ausgelegt werden, wodurch Kosten des Steuergeräts gesenkt werden. Durch die Möglichkeit, den zweiten Versorgungspfad zu sperren, können ferner Materialien und Komponenten eingespart werden, die anderenfalls zum Schutz gegen oben angesprochene Fehler, beispielsweise durch elektrochemische Migration bedingte Leckströme, eingespart werden. Insgesamt ist damit ein sicherer Betrieb des Mehrspannungsbordnetzes durch das erfindungsgemäße Steuergerät möglich.

Ist der zweite Versorgungspfad durch das Schaltungsmodul leitfähig geschaltet, so kann dem zweiten Steuermodul über den zweiten Versorgungsanschluss Strom bei der zweiten Versorgungsspannung zugeführt werden. Das Schaltungsmodul ist bevorzugt derart ausgestaltet, dass geringe bis keine Leitverluste entstehen.

Das Schaltungsmodul kann in einfacher Weise in bestehende Steuergeräte installiert werden oder bereits bei der Konzeption des Steuergeräts berücksichtigt werden. Das Schaltungsmodul lässt sich mit geringem Aufwand in dem Steuergerät installieren. Das Ansteuersignal kann insbesondere im Wesentlichen logiklos, also ohne Signalauswertung, erzeugt werden, was an späterer Stelle genauer erläutert werden wird. Damit erzielt die vorliegende Erfindung mit einfachen Mitteln einen signifikant sichereren Betrieb eines Mehrspannungsbordnetzes.

Nachfolgend werden die Komponenten des erfindungsgemäßen Steuergeräts näher erläutert:
Das erfindungsgemäße Steuergerät ist für einen Gebrauch in einem Mehrspannungsbordnetz eines Fahrzeugs ausgebildet. Es dient beispielsweise zur Steuerung einer Komponente, z.B. einer Pumpe, die bei der ersten Versorgungsspannung und/oder bei der zweiten Versorgungsspannung betrieben wird. Üblicherweise ist die zweite Versorgungsspannung größer als die erste Versorgungsspannung. Die erste Versorgungsspannung liegt beispielsweise bei 12 V und die zweite Versorgungsspannung bei 48 V. Beide Versorgungsspannungen sind bevorzugt Gleichspannungen.

Zum Steuern einer Komponente, die von dem ersten und/oder dem zweiten Teilnetz betrieben wird, umfasst das Steuergerät besagtes erstes Steuermodul, das für einen Betrieb bei der ersten Versorgungsspannung ausgebildet sein kann, und besagtes zweites Steuermodul, das für einen Betrieb bei der zweiten Versorgungsspannung ausgebildet sein kann.

Im Steuergerät ist ein erster Versorgungspfad vorgesehen, der das erste Steuermodul an einen ersten Versorgungsspannungsanschluss des Steuergeräts und/oder an einen ersten Masseanschluss des Steuergeräts anschließt, sodass das erste Steuermodul bei der ersten Versorgungsspannung mit Strom versorgt werden kann. Bei einem Normalbetrieb des Steuergeräts liegt am ersten Versorgungsspannungsanschluss beispielsweise die erste Versorgungsspannung an, sodass dem ersten Steuermodul Strom über den ersten Versorgungsspannungsanschluss bei der ersten Versorgungsspannung zugeführt wird. Die am ersten Versorgungsspannungsanschluss anliegende Spannung kann auch von der ersten Versorgungsspannung abweichen, beispielsweise im Falle eines Fehlers oder dann, wenn das Steuergerät in einen Ruhemodus versetzt wird oder ausgeschaltet wird. Die erste Versorgungsspannung ist beispielsweise eine Gleichspannung und beträgt beispielsweise etwa 12 V. In dem ersten Versorgungspfad kann ein Spannungswandler vorgesehen sein, insbesondere ein Gleichspannungswandler, sodass dem ersten Steuermodul über den ersten Versorgungspfad eine gewandelte erste Versorgungsspannung zugeführt werden kann.

Ferner ist ein zweiter Versorgungspfad vorgesehen, der das zweite Steuermodul an einem zweiten Versorgungsspannungsanschluss des Steuergeräts und/oder an einen zweiten Masseanschluss des Steuergeräts anschließt, sodass das zweite Steuermodul mit Strom bei der zweiten Versorgungsspannung versorgt werden kann. Bei einem Normalbetrieb des Steuergeräts liegt am zweiten Versorgungsspannungsanschluss beispielsweise die zweite Versorgungsspannung an, sodass dem zweiten Steuermodul Strom über den zweiten Versorgungsspannungsanschluss bei der zweiten Versorgungsspannung zugeführt wird. Die am zweiten Versorgungsspannungsanschluss anliegende Spannung kann aber auch von der zweiten Versorgungsspannung abweichen, beispielsweise im Falle eines Fehlers. Die zweite Versorgungsspannung ist beispielsweise eine Gleichspannung und beträgt beispielsweise etwa 48 V. In dem zweiten Versorgungspfad kann ebenfalls ein Spannungswandler vorgesehen sein, insbesondere ein Gleichspannungswandler, sodass dem zweiten Steuermodul über den zweiten Versorgungspfad eine gewandelte zweite Versorgungsspannung zugeführt werden kann.

Beispielsweise umfasst das Steuergerät ein Gehäuse, in welchem sowohl das erste Steuermodul als auch das zweite Steuermodul integriert sind. Die beiden Versorgungsspannungsanschlüsse und die beiden Masseanschlüsse bilden Schnittstellen aus, über die das Steuergerät die erste Versorgungsspannung und die zweite Versorgungsspannung empfangen kann. Beispielsweise sind die beiden Masseanschlüsse am Gehäuse räumlich getrennt voneinander angeordnet, jedoch außerhalb des Steuergeräts auf dieselbe Masse geschaltet, beispielsweise auf die Fahrzeugmasse.

Das erste Steuermodul muss nun nicht notwendigerweise als integriertes Modul ausgebildet sein, sondern kann ein oder mehrere erste Steuerelemente und weitere erste Komponenten umfassen, die auch räumlich getrennt voneinander angeordnet sein können. Gleiches gilt sinngemäß für das zweite Steuermodul.

Das erste Steuermodul umfasst beispielsweise einen Microcontroller. Das zweite Steuermodul umfasst beispielsweise einen Steuersignalsenderempfänger, wie einen Local-Interconnect-Network-(LIN-) Transceiver. Beispielsweise umfasst das zweite Steuermodul neben dem Steuersignalsenderempfänger keine weiteren Steuerungskomponenten, insbesondere keinen weiteren Microcontroller.

Das erste Steuermodul und das zweite Steuermodul sind über wenigstens einen Steuersignalpfad aneinander gekoppelt, sodass Steuersignale von dem ersten Steuermodul zum zweiten Steuermodul und/oder Steuersignale vom zweiten Steuermodul hin zum ersten Steuermodul übertragen werden können.

Bei der ersten Versorgungsspannung und bei der zweiten Versorgungsspannung handelt es sich bevorzugt jeweils um eine Gleichspannung. Sowohl der erste Versorgungspfad als auch der zweite Versorgungspfad können jeweils einen oder mehrere Gleichspannungswandler umfassen, sodass ersten Komponenten des ersten Steuermoduls und/oder zweiten Komponenten des zweiten Steuermoduls gewandelte Versorgungsspannungen bereitgestellt werden können. Derartige Gleichspannungswandler können auch als Teil des ersten Steuermoduls bzw. als Teil des zweiten Steuermoduls ausgebildet sein, anstelle in den betreffenden Versorgungspfaden installiert zu sein.

Der zweite Versorgungspfad enthält erfindungsgemäß das Schaltungsmodul, das den zweiten Versorgungspfad in Abhängigkeit von dem Ansteuersignal sperrt oder leitfähig schaltet, um entweder die Stromversorgung bei der zweiten Versorgungsspannung zu unterbinden oder sicherzustellen. Im Falle des gesperrten zweiten Versorgungspfades wird dem zweiten Steuermodul also kein Strom bereitgestellt. Das Schaltungsmodul kann wahlweise in einem ersten Teil des zweiten Versorgungspfades installiert sein, der zwischen dem zweiten Versorgungsspannungsanschluss und einem Versorgungseingang des zweiten Steuermoduls liegt, und/oder in einem zweiten Teil des zweiten Versorgungspfades, der zwischen einem Versorgungsausgang des zweiten Steuermoduls und dem zweiten Masseanschluss liegt. In allen Fällen führt ein Sperren des zweiten Versorgungspfades durch das Schaltungsmodul zu einer Unterbindung des Stromflusses über den zweiten Versorgungspfad und ein leitfähig-Schalten zu einer Sicherstellung des Stromflusses über den zweiten Versorgungspfad.

Beispielsweise ist das Schaltungsmodul ausgebildet in Abhängigkeit von dem Ansteuersignal wahlweise einen eingeschalteten Zustand oder einen ausgeschalteten Zustand einzunehmen, wobei im eingeschalteten Zustand der zweite Versorgungspfad leitfähig ist, um die Stromversorgung bei der zweiten Versorgungsspannung sicherzustellen, und wobei im ausgeschalteten Zustand des Schaltungsmoduls der zweite Versorgungspfad gesperrt ist, um die Stromversorgung bei der zweiten Versorgungsspannung zu unterbinden. Eine derartige Funktion des Schaltungsmoduls kann beispielsweise durch einen ansteuerbaren Schalter gewährleistet werden, der einen Ansteuersignaleingang zum Empfangen des Ansteuersignals umfasst und ausgebildet ist, in Abhängigkeit von dem Ansteuersignal geschaltet zu werden. Beispielsweise handelt es sich bei dem ansteuerbaren Schalter um einen MOSFET, wie beispielsweise einen p-Kanal-MOSFET, oder um einen anderen Transistortyp. Bevorzugt weist der ansteuerbare Schalter einen niedrigen Leitwiderstand auf, um im eingeschalteten Zustand möglichst geringe bis keine Leitverluste zu verursachen. Die Leitverluste entstehen, wenn dem zweiten Steuermodul über den zweiten Versorgungspfad, welcher das Schaltungsmodul enthält, Strom bei der zweiten Versorgungsspannung zugeführt wird. Dieser Strom fließt dann auch über den ansteuerbaren Schalter.

Nachfolgend werden weitere bevorzugte Ausführungsformen des erfindungsgemäßen Steuergeräts beschrieben. Die weiteren Merkmale dieser bevorzugten Ausführungsformen können miteinander als auch mit den bereits oben beschriebenen optionalen Merkmalen zur Ausbildung weiterer Ausführungsformen kombiniert werden, sofern sie nicht ausdrücklich als alternativ zueinander beschrieben sind.

Erfindungsgemäß ist das Steuergerät ausgebildet, das Ansteuersignal in Abhängigkeit von einer am ersten Versorgungsspannungsanschluss anliegenden Spannung zu erzeugen.

Liegt am ersten Versorgungsspannungsanschluss beispielsweise die erste Versorgungsspannung an, also beispielsweise 12 V, so erzeugt das Steuergerät das Ansteuersignal bevorzugt derart, dass das Schaltungsmodul den zweiten Versorgungspfad nicht sperrt, sondern leitfähig schaltet, um die Stromversorgung für das zweite Steuermodul bei der zweiten Versorgungsspannung sicherzustellen.

Weicht die am ersten Versorgungsspannungsanschluss anliegende Spannung von der ersten Versorgungsspannung ab, beispielweise, weil ein Fehlerfall vorliegt und/oder das Steuergerät in einen Ruhemodus übergegangen ist, so erzeugt das Steuergerät das Ansteuersignal bevorzugt derart, dass das Schaltungsmodul den zweiten Versorgungspfad sperrt, um die Stromversorgung für das zweite Steuermodul bei der zweiten Versorgungsspannung zu unterbinden.

Ein derartiges Erzeugen des Ansteuersignals durch das Steuergerät in Abhängigkeit von der am ersten Versorgungsspannungsanschluss anliegenden Spannung kann in einfacher Weise mittels eines Transistors umgesetzt werden, was an späterer Stelle näher erläutert werden wird. Diese Ausführungsform hat jedenfalls den Vorteil, dass der zweite Versorgungspfad automatisch gesperrt werden kann, wenn die am ersten Versorgungsspannungsanschluss anliegende Spannung von der ersten Versorgungsspannung, beispielsweise 12V, abweicht. Wird das erste Steuermodul beispielsweise in einen Ruhemodus versetzt, indem die erste Versorgungsspannung abgestellt wird, die Spannung am ersten Versorgungspannungsanschluss also etwa 0 V beträgt, so führt dieses Versetzen in den Ruhemodus automatisch dazu, dass der zweite Versorgungspfad gesperrt wird. Auf diese Weise wird automatisch sichergestellt, dass keine Kurzschlüsse und/oder Kriechströme oder Leckströme in dem zweiten Steuergerät entstehen. Die Erzeugung des Ansteuersignals in Abhängigkeit von der am ersten Versorgungsspannungsanschluss anliegenden Spannung kann im Wesentlichen "logiklos", also ohne Signalauswertung erfolgen. Es ist in dem Steuergerät beispielsweise lediglich schaltungstechnisch sichergestellt, dass ein Abweichen der am ersten Versorgungsspannungsanschluss anliegenden Spannung von der ersten Versorgungsspannung dazu führt, dass das Schaltungsmodul den zweiten Versorgungspfad sperrt, und beim Anliegen der ersten Versorgungsspannung am ersten Versorgungsspannungsanschluss leitfähig schaltet, sodass das zweite Steuermodul mit Strom bei der zweiten Versorgungsspannung versorgt werden kann.

Bei einer weiteren bevorzugten Ausführungsform ist das Steuergerät ausgebildet, das Ansteuersignal in Abhängigkeit von einem Fehlersignal und/oder in Abhängigkeit von einer fehlerhaften Versorgungsspannung zu erzeugen, wobei die fehlerhafte Versorgungsspannung dann vorliegt, wenn wenigstens eines des Folgenden zutrifft:
- das erste Steuermodul ist nicht mehr an den ersten Masseanschluss angeschlossen;
- das zweite Steuermodul ist nicht mehr an den zweiten Masseanschluss angeschlossen;
- ein Kurzschluss in einem ersten Teilnetz des Mehrspannungsbordnetzes und/oder in einem zweiten Teilnetz des Mehrspannungsbordnetzes, wobei das erste Teilnetz bei der ersten Versorgungsspannung und das zweite Teilnetz bei der zweiten Versorgungsspannung betrieben wird; oder
- ein Potentialunterschied zwischen dem ersten Masseanschluss und dem zweiten Masseanschluss überschreitet einen Schwellenwert.

Um eine derartige fehlerhafte Versorgungsspannung zu detektieren und/oder um ein derartiges Fehlersignal zu empfangen, kann das Steuergerät eine Auswerteeinheit aufweisen. Eine derartige Auswerteeinheit kann zum Detektieren der fehlerhaften Versorgungsspannung und/oder zum Erzeugen oder Empfangen des Fehlersignals an den ersten Versorgungsspannungsanschluss, an den zweiten Versorgungsspannungsanschluss, an den ersten Masseanschluss und/oder an den zweiten Masseanschluss gekoppelt sein.

Die fehlerhafte Versorgungsspannung liegt beispielsweise dann vor, wenn das erste Steuermodul und/oder das zweite Steuermodul nicht mehr auf Masse geschaltet ist/sind. Ein solcher Vorfall wird auch als "Masseabriss" oder "Masseverlust" bezeichnet. Ferner liegt die fehlerhafte Versorgungsspannung vor, wenn im ersten Teilnetz und/oder im zweiten Teilnetz ein Kurzschluss entstanden ist und/oder ein Potentialunterschied zwischen den beiden Masseanschlüssen einen Schwellenwert, wie beispielsweise +/- 1 V, überschreitet. Letzterer Fehlerfall wird auch als "Masseversatz" bezeichnet. Der Betrag des Schwellenwerts kann vorgegeben sein.

Beispielsweise erzeugt das Steuergerät das Ansteuersignal für das Schaltungsmodul im Falle einer fehlerhaften Versorgungsspannung derart, dass das Schaltungsmodul den zweiten Versorgungspfad sperrt, um die Versorgung des zweiten Steuermoduls bei der zweiten Versorgungsspannung zu unterbinden. Liegt keine fehlerhafte Versorgungsspannung und kein Fehlersignal vor, erzeugt das Steuergerät das Ansteuersignal beispielsweise derart, dass das Schaltungsmodul den zweiten Versorgungspfad leitfähig schaltet, sodass das zweite Steuermodul mit Strom bei der zweiten Versorgungsspannung versorgt werden kann.

Beispielsweise ist eine Überwachungseinheit zum Überwachen des Mehrspannungsbordnetzes vorgesehen. Beispielsweise führt die Überwachungseinheit des Mehrspannungsbordnetzes dem Steuergerät das Fehlersignal zu. Die Überwachungseinheit erzeugt das Fehlersignal beispielsweise, wenn in dem Mehrspannungsbordnetz ein Zustand entsteht, der ein Abschalten der zweiten Versorgungsspannung in dem Steuergerät erfordert oder bei dem ein Abschalten der zweiten Versorgungsspannung in dem Steuergerät zweckmäßig ist. Beispielsweise generiert das Steuergerät auf den Empfang des Fehlersignals hin das Ansteuersignal derart, dass dieses das Schaltungsmodul veranlasst, den zweiten Versorgungspfad zu sperren.

Die oben beschriebenen Ausführungsformen können auch miteinander kombiniert werden. Beispielsweise ist das Steuergerät ausgebildet, das Ansteuersignal für das Schaltungsmodul sowohl in Abhängigkeit der am ersten Versorgungsspannungsanschluss anliegenden Spannung als auch in Abhängigkeit von einer fehlerhaften Versorgungsspannung und/oder in Abhängigkeit von dem Fehlersignal zu erzeugen. Beispielsweise erzeugt das Steuergerät das Ansteuersignal derart, dass der zweite Versorgungspfad nur dann durch das Schaltungsmodul leitfähig geschaltet ist, wenn die am ersten Versorgungsspannungsanschluss anliegende Spannung nicht von der ersten Versorgungsspannung abweicht, keine wie auch immer geartete fehlerhafte Versorgungsspannung vorliegt und kein Fehlersignal anliegt. Sobald eine fehlerhafte Versorgungsspannung vorliegt und/oder das Fehlersignal anzeigt, dass das Sperren des zweiten Versorgungspfades erforderlich oder zweckmäßig ist, und/oder sobald die am ersten Versorgungsspannungsanschluss anliegende Spannung von der ersten Versorgungsspannung abweicht, erzeugt das Steuergerät das Ansteuersignal für das Schaltungsmodul derart, dass das Schaltungsmodul den zweiten Versorgungspfad sperrt, sodass die Versorgung des zweiten Steuermoduls mit Strom bei der zweiten Versorgungsspannung unterbunden wird.

Bei einer weiteren bevorzugten Ausführungsform des Steuergeräts ist das Schaltungsmodul über einen Ansteuersignalpfad an den ersten Versorgungsspannungsanschluss angeschlossen, um das Ansteuersignal zu empfangen. Bei dieser Ausführungsform wirkt sich die am ersten Versorgungsspannungsanschluss anliegende Spannung unmittelbar auf das Ansteuersignal und damit unmittelbar auf den Zustand des Schaltungsmoduls aus.

Beispielsweise enthält der Ansteuersignalpfad einen Transistor, der einen Transistorsteuereingang, einen Leistungssignaleingang und einen Leistungssignalausgang aufweist. Beispielsweise ist der Transistorsteuereingang an den ersten Versorgungsspannungsanschluss gekoppelt, sodass die am ersten Versorgungsspannungsanschluss anliegende Spannung den Transistor steuert. Der Leistungssignalausgang des Transistors ist beispielsweise an den zweiten Masseanschluss gekoppelt und der Leistungssignaleingang sowohl an den zweiten Versorgungsspannungsanschluss als auch an das Schaltungsmodul, um dem Schaltungsmodul das Ansteuersignal zuzuführen. Der Transistor des Steuergeräts erzeugt also das Ansteuersignal für das Schaltungsmodul in Abhängigkeit der am ersten Versorgungsspannungsanschluss anliegenden Spannung.

Der Transistor ist beispielsweise derart im Ansteuersignalpfad angeordnet, dass die am ersten Versorgungsspannungsanschluss anliegende erste Versorgungsspannung dazu führt, dass das durch den Transistor erzeugte Ansteuersignal das Schaltungsmodul veranlasst, den zweiten Versorgungspfad leitfähig zu schalten, und derart, dass eine von der ersten Versorgungsspannung abweichende Spannung am ersten Versorgungsspannungsanschluss dazu führt, dass das durch den Transistor erzeugte Ansteuersignal das Schaltungsmodul veranlasst, den zweiten Versorgungspfad zu sperren.

Wie gesagt enthält das Schaltungsmodul bei einer bevorzugten Ausführungsform des erfindungsgemäßen Steuergeräts einen ansteuerbaren Schalter, wobei der ansteuerbare Schalter bevorzugt einen Ansteuersignaleingang zum Empfangen des Ansteuersignals aufweist und ausgebildet ist, in Abhängigkeit von dem Ansteuersignal geschaltet zu werden. Der ansteuerbare Schalter ist beispielsweise ein Transistor, beispielsweise ein p-Kanal-MOSFET, der bevorzugt einen niedrigeren Leitwiderstand umfasst, sodass Leitverluste weitgehend vermieden werden können, wenn das zweite Steuermodul Strom über den zweiten Versorgungspfad bezieht.

Beispielsweise weist der ansteuerbare Schalter ferner einen Stromsignaleingang und einen Stromsignalausgang auf, wobei der Stromsignaleingang bevorzugt auf den zweiten Versorgungsspannungsanschluss geschaltet ist und der Stromsignalausgang bevorzugt auf einen Versorgungseingang des zweiten Steuermoduls. Alternativ dazu ist der Stromsignaleingang auf einen Versorgungsausgang des zweiten Steuermoduls geschaltet und der Stromsignalausgang auf den zweiten Masseanschluss.

Das Schaltungsmodul mit dem ansteuerbaren Schalter kann also wahlweise in einem ersten Teil des zweiten Versorgungspfads enthalten sein, der zwischen dem zweiten Versorgungsspannungsanschluss und dem Versorgungseingang des zweiten Steuermoduls liegt, oder in einem zweiten Teil des zweiten Versorgungspfades, der zwischen dem Versorgungsausgang des zweiten Steuermoduls und dem zweiten Masseanschluss liegt. Über den Versorgungseingang bezieht das zweite Steuermodul Strom bei der zweiten Versorgungsspannung (oder einer gewandelten zweiten Versorgungsspannung) und über den Versorgungsausgang gibt das zweite Steuermodul Strom aus.

Bevorzugt ist jedoch, dass das Schaltungsmodul mit dem ansteuerbaren Schalter im besagten ersten Teil des zweiten Versorgungspfades, also zwischen dem zweiten Versorgungsspannungsanschluss und dem Versorgungseingang des zweiten Steuermoduls geschaltet ist. Ist der zweite Versorgungspfad durch das Schaltungsmodul gesperrt, so ist dann sichergestellt, dass das zweite Steuermodul nicht mit der zweiten Versorgungsspannung beauflagt wird. Bevorzugt ist ferner, dass der ansteuerbare Schalter des Schaltungsmoduls in unmittelbarer Nähe zum zweiten Versorgungsspannungsanschluss angeordnet ist, sodass bei gesperrtem zweiten Versorgungspfad die am zweiten Versorgungsspannungsanschluss anliegende Spannung lediglich in der Nähe des zweiten Versorgungsspannungsanschluss anliegt, jedoch nicht in anderen Bereichen des Steuergeräts. Der Abstand zwischen dem Stromsignaleingang des ansteuerbaren Schalters und dem zweiten Versorgungsspannungsanschluss ist also bevorzugt gering und beträgt beispielsweise weniger als 1 cm.

Bei einer weiteren bevorzugten Ausführungsform ist der Leistungssignaleingang des Transistors des Steuergerätes an den Ansteuersignaleingang des ansteuerbaren Schalters des Schaltungsmoduls gekoppelt, beispielsweise über einen ersten ohmschen Widerstand. Der Ansteuersignaleingang ist bevorzugt ferner an den zweiten Versorgungsspannungsanschluss gekoppelt, beispielsweise über einen zweiten ohmschen Widerstand. Die beiden ohmschen Widerstände bilden einen Spannungsteiler aus, und die zwischen den beiden ohmschen Widerständen anliegende Spannung stellt das Ansteuersignal für den ansteuerbaren Schalter dar.

Der ansteuerbare Schalter wird also bevorzugt in Abhängigkeit von einer Spannung geschaltet, die zwischen den beiden ohmschen Widerständen anliegt. Der Wert der dort anliegenden Spannung wird im Ergebnis bestimmt durch die Spannung, die an dem ersten Versorgungsspannungsanschluss anliegt, da letztere den Transistor und damit einen Strom steuert, der über die beiden ohmschen Widerstände fließt. Ist der Transistor eingeschaltet, so sind die beiden ohmschen Widerstände in Serie geschaltet und über die beiden ohmschen Widerstände fällt im Wesentlichen die am zweiten Versorgungsspannungsanschluss anliegende Spannung ab. Wenigstens einer der beiden ohmschen Widerstände ist bevorzugt hochohmig, sodass im Falle eines eingeschalteten Transistors geringe, idealerweise keine Leitverluste entstehen. Ist der Transistor aufgrund der am ersten Versorgungsspannungsanschluss anliegenden Spannung ausgeschaltet, so fließt über die beiden ohmschen Widerstände kein Strom, sodass die zwischen den beiden ohmschen Widerständen anliegende Spannung dazu führt, dass der ansteuerbare Schalter den zweiten Versorgungspfad sperrt. In diesem Fall wird der Stromfluss über den zweiten Versorgungspfad unterbunden.

Anstelle eines ohmschen Widerstands kann auch ein anderer Impedanz-Typ vorgesehen sein, um besagten Spannungsteiler auszubilden.

Erfindungsgemäß weist das erste Steuermodul einen Steuersignalsenderempfänger auf, beispielsweise einen Local-Interconnect-Network-(LIN-) Transceiver, der über wenigstens einen Steuersignalpfad an das zweite Steuermodul gekoppelt ist, um dem zweiten Steuermodul ein erstes Steuersignal bereitzustellen und/oder von dem zweiten Steuermodul ein zweites Steuersignal zu empfangen. Das erste Steuermodul und das zweite Steuermodul sind also über den wenigstens einen Steuersignalpfad kommunikativ aneinander gekoppelt. Sowohl das erste und das zweite Steuermodul als auch der wenigstens eine Steuersignalpfad können bei einer weiteren Ausführungsform des erfindungsgemäßen Steuergeräts in dem Gehäuse des Steuergeräts integriert sein.

Gemäß einem zweiten Aspekt der vorliegenden Erfindung wird die oben genannte Aufgabe gelöst durch ein Verfahren zum Betreiben eines Steuergeräts für ein Mehrspannungsbordnetz eines Fahrzeugs mit den Merkmalen des unabhängigen Patentanspruchs 12.

Das Verfahren des zweiten Aspektes der Erfindung teilt die Vorteile des Steuergeräts des ersten Aspektes der Erfindung. Bevorzugte Ausführungsformen des Verfahrens entsprechen den oben geschilderten bevorzugten Ausführungsformen des Steuergeräts des ersten Aspektes der Erfindung, insbesondere, wie sie in den abhängigen Ansprüchen definiert sind.

Das Ansteuersignal wird in Abhängigkeit von einer am ersten Versorgungsspannungsanschluss anliegenden Spannung erzeugt. Zusätzlich dazu kann das Ansteuersignal bei einer weiteren bevorzugten Ausführungsform in Abhängigkeit von einem Fehlersignal und/oder in Abhängigkeit von einer fehlerhaften Versorgungsspannung erzeugt werden. Weiter oben sind bereits Beispiele für eine fehlerhafte Versorgungsspannung sowie Beispiele für das Erzeugen des Fehlersignals angegeben worden.

Weitere Merkmale und Vorteile der Erfindung werden bei der nachfolgenden Beschreibung von Ausführungsbeispielen anhand der Figuren deutlich.

Es zeigen:
- Fig. 1: eine schematische und exemplarische Darstellung einer ersten Ausführungsform eines Steuergeräts gemäß dem ersten Aspekt der Erfindung; und
- Fig. 2: eine schematische und exemplarische Darstellung einer beispielhaften Implementierung des in der Fig. 1 dargestellten Steuergeräts.

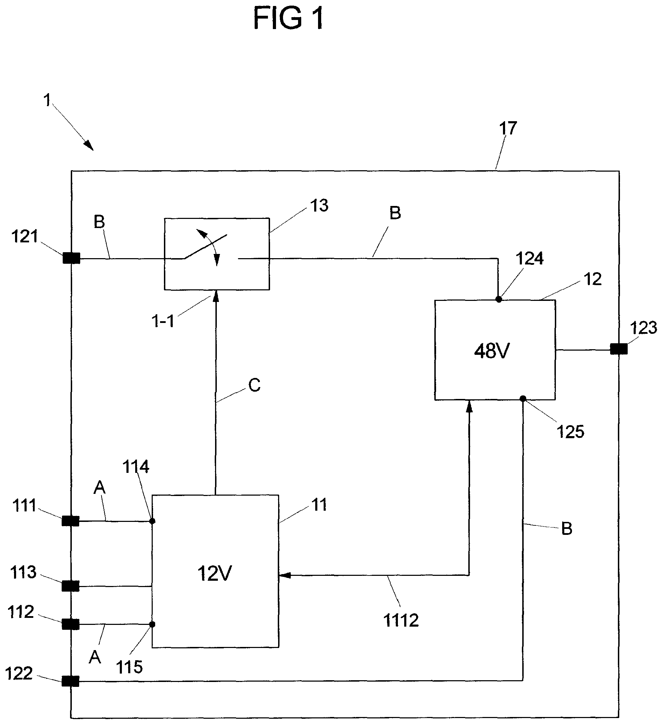

Die Fig. 1 zeigt eine schematische exemplarische Darstellung einer ersten Ausführungsform eines Steuergeräts 1. Das Steuergerät 1 ist für den Einsatz in einem Mehrspannungsbordnetz eines Fahrzeuges, beispielsweise eines PKWs, vorgesehen. Beispielsweise handelt es sich bei dem Mehrspannungsbordnetz um das bekannte 12 V / 48 V-Mehrspannungsbordnetzes eines PKWs.

Das Steuergerät 1 umfasst ein erstes Steuermodul (12 V) 11 und ein zweites Steuermodul (48 V) 12. Beide Steuermodule 11 und 12 sind in einem Gehäuse 17 des Steuergeräts 1 angeordnet. An dem Gehäuse 17 sind mehrere Anschlüsse vorgesehen. Über einen ersten Versorgungsspannungsanschluss 111 und einen ersten Masseanschluss 112 ist dem Steuergerät 1 eine erste Versorgungsspannung zugeführt. Bei einem Normalbetrieb des Steuergeräts 1 liegt am ersten Versorgungsspannungsanschluss 111 die erste Versorgungsspannung von beispielsweise 12 V an.

Über einen zweiten Versorgungsspannungsanschluss 121 und über einen zweiten Masseanschluss 122 ist dem Steuergerät 1 eine zweite Versorgungsspannung von beispielsweise 48 V zugeführt. Beispielsweise sind beide Masseanschlüsse 112 und 122 außerhalb des Steuergeräts 1, also außerhalb des Gehäuses 17, auf einen gemeinsamen Masseanschluss, beispielsweise auf Fahrzeugmasse, geschaltet.

Ferner ist eine erste Steuersignalschnittstelle 113 vorgesehen, über die das erste Steuermodul 11 Signale ausgeben kann und/oder Signale empfangen kann. Außerdem ist eine zweite Steuersignalschnittstelle 123 vorgesehen, über die das zweite Steuermodul 12 Signale ausgeben kann und/oder Signale empfangen kann. Das erste Steuermodul 11 und das zweite Steuermodul 12 sind über wenigstens einen Steuersignalpfad 1112 aneinander gekoppelt, sodass das erste Steuermodul 11 dem zweiten Steuermodul 12 ein erstes Steuersignal zuführen kann und/oder von dem zweiten Steuermodul 12 ein zweites Steuersignal empfangen kann.

Um die beiden Steuermodule 11 und 12 jeweils mit einem für den jeweiligen Betrieb erforderlichen Strom zu versorgen, sind ein erster Versorgungspfad A und ein zweiter Versorgungspfad B vorgesehen.

Der erste Versorgungspfad A schließt das erste Steuermodul 11 an den ersten Versorgungsspannungsanschluss 111 und an den ersten Masseanschluss 112 an. Über diesen ersten Versorgungspfad A wird dem ersten Steuermodul 11 Strom bei der ersten Versorgungsspannung zugeführt.

Der zweite Versorgungspfad B schließt das zweite Steuermodul 12 an den zweiten Versorgungsspannungsanschluss 121 und an den zweiten Masseanschluss 122 an. Über den zweiten Versorgungspfad B wird dem zweiten Steuermodul 12 bei Normalbetrieb des Steuergeräts 1 Strom bei der zweiten Versorgungsspannung zugeführt.

Das erste Steuermodul 11 umfasst zum Empfangen und Ausgeben von Strom einen ersten Versorgungseingang 114, dem die am ersten Versorgungsspannungsanschluss 111 anliegende Spannung über den ersten Versorgungspfad A zugeführt ist, und einen ersten Versorgungsausgang 115, der über den ersten Versorgungspfad A auf den ersten Masseanschluss 112 geschaltet ist. Ebenso umfasst das zweite Steuermodul 12 zum Empfangen und Ausgeben von Strom einen Versorgungseingang 124, der über den zweiten Versorgungspfad B an den zweiten Versorgungsspannungsanschluss 121 gekoppelt ist und einen Versorgungsausgang 125, der über den zweiten Versorgungspfad B auf den zweiten Masseanschluss 122 geschaltet ist.

In den Versorgungspfaden A und B können jeweils auch ein oder mehrere Spannungswandler vorgesehen sein, um den Steuermodulen 11 und 12 gewandelte Versorgungsspannungen bereitzustellen. Diese Spannungswandler sind in den Figuren jedoch nicht dargestellt.

Das Steuergerät 1 umfasst ferner ein Schaltungsmodul 13, das in dem zweiten Versorgungspfad B angeordnet ist. In Abhängigkeit von einem Ansteuersignal 1-1 sperrt das Schaltungsmodul 13 den zweiten Versorgungspfad B oder schaltet diesen leitfähig, um die Stromversorgung bei der zweiten Versorgungsspannung zu unterbinden oder sicherzustellen. Die Sperrung des zweiten Versorgungspfades B durch das Schaltungsmodul 13 bewirkt, dass über den zweiten Versorgungspfad B kein Strom fließt.

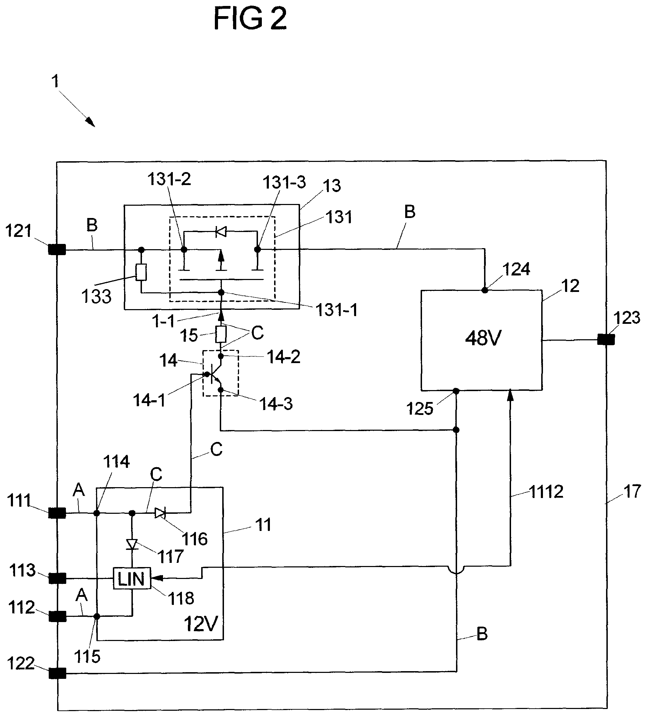

Zum Empfangen des Ansteuersignals 1-1 umfasst das Steuergerät 1 einen Ansteuersignalpfad C, der an den ersten Versorgungsspannungsanschluss 111 angeschlossen ist, sodass das Schaltungsmodul 13 das Ansteuersignal 1-1 empfangen kann. Dies soll nun anhand eines in der Fig. 2 dargestellten Beispiels näher erläutert werden.

Fig. 2 zeigt eine beispielhafte Implementierung des in der Fig. 1 dargestellten Steuergeräts 1, wobei gleiche Komponenten des Steuergeräts 1 mit gleichen Bezugsziffern gekennzeichnet sind.

Bei dem Ausführungsbeispiel gemäß der Fig. 2 umfasst das Schaltungsmodul 13 einen ansteuerbaren Schalter 131 (im Folgenden auch schlicht als ,Schalter' 131 bezeichnet). Der Schalter 131 wird in Abhängigkeit des Ansteuersignals 1-1 geschaltet. Im eingeschalteten Zustand schaltet der Schalter 131 den zweiten Versorgungspfad B leitfähig, sodass die Stromversorgung über den zweiten Versorgungspfad B sichergestellt wird. Im eingeschalteten Zustand empfängt das zweite Steuermodul 12 also einen Strom bei der am zweiten Versorgungsspannungsanschluss 121 anliegenden Spannung. Im ausgeschalteten Zustand sperrt der Schalter 131 den zweiten Versorgungspfad B. Der Stromfluss über den zweiten Versorgungspfad B wird dadurch unterbunden, sodass das zweite Steuermodul 12 nicht mit einem Strom versorgt wird. Die am zweiten Versorgungsspannungsanschluss 121 anliegende Spannung liegt also auch nicht am zweiten Versorgungseingang 124 an.

Bei dem in der Fig. 2 dargestellten Beispiel handelt es sich bei dem ansteuerbaren Schalter 131 um einen p-Kanal MOSFET. Grundsätzlich kommen jedoch auch andere Transistortypen für die Implementierung der Funktion des Schaltermoduls 13 in Betracht. Zweckmäßig ist jedoch, dass der eingesetzte Schalter/Transistor einen niedrigen Leitwiderstand aufweist, um im eingeschalteten Zustand möglichst niedrige, idealerweise keine Leitverluste zu verursachen.

Der ansteuerbare Schalter 131 wird durch das Ansteuersignal 1-1 gesteuert. Bei dem in der Fig. 2 gezeigten Beispiel wird dem Schaltungsmodul 13, also dem ansteuerbaren Schalter 131, das Ansteuersignal 1-1 über den Ansteuersignalpfad C zugeführt. Der Ansteuersignalpfad C verbindet das Schaltungsmodul 13 mit dem ersten Versorgungsspannungsanschluss 111. Mit anderen Worten: Das Steuergerät 1 erzeugt das Ansteuersignal 1-1 in Abhängigkeit von der am ersten Versorgungsspannungsanschluss 111 anliegenden Spannung.

Der Ansteuersignalpfad C umfasst einen Transistor 14, der einen Transistorsteuereingang 14-1, einen Leistungssignalausgang 14-3 und einen Leistungssignaleingang 14-2 aufweist. Der Transistorsteuereingang 14-1 ist über eine erste Diode 116 an den ersten Versorgungsspannungsanschluss 111 angeschlossen. Der Leistungssignalausgang 14-3 ist auf den zweiten Masseanschluss 122 geschaltet, beispielsweise über den zweiten Versorgungspfad B, wie es in der Fig. 2 dargestellt ist. Der Leistungssignaleingang 14-2 des Transistors 14 ist über einen ersten ohmschen Widerstand 15 an einen Ansteuersignaleingang 131 des ansteuerbaren Schalters 131 angeschlossen. Im Falle eines MOSFETs handelt es sich bei dem Ansteuersignaleingang 131-1 um den Gateanschluss. Der Ansteuersignaleingang 131-1 ist über einen zweiten ohmschen Widerstand 133 an den zweiten Versorgungsspannungsanschluss 121 geschaltet. Ein Stromsignaleingang 131-1 des ansteuerbaren Schalters 131 ist ebenfalls auf den zweiten Versorgungsspannungsanschluss 121 geschaltet. Im Falle eines MOSFETs handelt es sich bei dem Stromsignaleingang 131-2 beispielsweise um einen Source-Anschluss. Ein Stromsignalausgang 131-3 des Schalters 131 ist auf den Versorgungseingang 124 des zweiten Steuermoduls geschaltet. Im Falle eines MOSFETs handelt es sich bei dem Stromsignalausgang 131-3 beispielsweise um einen Drain-Anschluss.

Der Transistor 14 ist beispielsweise ein Bipolartransistor, wie ein npn-Transistor. In diesem Fall handelt es sich bei dem Transistorsteuereingang 14-1 um einen Basisanschluss, bei dem Leistungssignalausgang 14-3 um einen Emitter-Anschluss und bei dem Leistungssignaleingang 14-2 um einen Kollektor-Anschluss.

Liegt am ersten Versorgungsspannungsanschluss 111 die erste Versorgungsspannung von beispielsweise 12 V an, so ist der Transistor 14 eingeschaltet. Daher fließt über den ersten ohmschen Widerstand 15 und den zweiten ohmschen Widerstand 133 ein Strom, der durch die am zweiten Versorgungsspannungsanschluss 121 anliegende Spannung erzeugt wird. Die beiden ohmschen Widerstände 15 und 133 bilden einen Spannungsteiler aus, der die Spannung am Ansteuersignaleingang 131-1 vorgibt. Diese Spannung stellt das Ansteuersignal 1-1 dar.

Da im eingeschalteten Zustand des Transistors 14 über den durch die beiden ohmschen Widerstände 15 und 133 ausgebildeten Spannungsteiler eine Spannung abfällt, führt die am Ansteuersignaleingang 131-1 anliegende Spannung dazu, dass der ansteuerbare Schaltung 131 eingeschaltet wird, also den zweiten Versorgungspfad B leitfähig schaltet. Dann wird dem zweiten Steuermodul 12 über den zweiten Versorgungspfad B ein Strom bei der am zweiten Versorgungsspannungsanschluss 121 anliegenden Spannung bereitgestellt. Diese Spannung ist bei Normalbetrieb des Steuergeräts 1 identisch zu der zweiten Versorgungsspannung, also beispielsweise 48 V.

Weicht die am ersten Versorgungsspannungsanschluss 111 anliegende Spannung von der ersten Versorgungsspannung ab, fällt sie beispielsweise auf etwa 0 V, beispielsweise, weil eine fehlerhafte Versorgungsspannung vorliegt und/oder das Steuergerät 1 in einen Ruhemodus überführt werden soll, so sperrt der Transistor 14. Dies führt automatisch dazu, dass die am Ansteuersignaleingang 131-1 anliegende Spannung fällt bzw. bei 0 V liegt, sodass der ansteuerbare Schalter 131 ausgeschaltet wird und den zweiten Versorgungspfad B sperrt. In diesem Zustand fließt über den zweiten Versorgungspfad kein Strom, sodass das zweite Steuermodul 12 nicht mit Strom versorgt wird.

Aus Sicherheitsgründen ist in dem Ansteuersignalpfad C die erste Diode 116 vorgesehen. Die erste Diode 116 stellt sicher, dass im Falle eines Defekts des Transistors 14 die am zweiten Versorgungsspannungsanschluss 121 anliegende Spannung keinesfalls dem ersten Versorgungsspannungsanschluss 111 zugeführt wird, sondern über die Diode 116 abfällt.

Das erste Steuermodul 111 umfasst bei dem in der Fig. 2 dargestellten Beispiel einen Steuersignalsenderempfänger (LIN) 118, der über den Steuersignalpfad 1112 an das zweite Steuermodul 12 gekoppelt ist. Der Steuersignalsenderempfänger 118 ist beispielsweise als LIN-Transceiver ausgestaltet. Der Steuersignalsenderempfänger 118 ist über eine zweite Diode 117 an den ersten Versorgungsspannungsanschluss 111 gekoppelt. Die zweite Diode 117 realisiert einen Verpolungsschutz für den Steuersignalsenderempfänger 118.

Die in den beiden Figuren gezeigten Ausführungsbeispiele des Steuergeräts 1 sind mit Bezug auf ein Mehrspannungsbordnetz des Typs 12 V/48 V erläutert worden. Die vorliegende Erfindung ist jedoch nicht auf diesen Typ eines Mehrspannungsbordnetzes beschränkt; vielmehr können die erste Versorgungsspannung und die zweite Versorgungsspannung auch andere Werte als 12 V bzw. 48 V betragen.

Ferner ist das Schaltungsmodul 13 bei den gezeigten Ausführungsbeispielen in einem ersten Teil des zweiten Versorgungspfades B zwischen dem zweiten Versorgungsspannungsanschluss 121 und dem zweiten Versorgungseingang 124 des zweiten Steuermoduls 12 angeordnet. Das Schaltungsmodul 13 könnte jedoch auch in einem zweiten Teil des zweiten Versorgungspfades B zwischen dem zweiten Versorgungsausgang 125 des zweiten Steuermoduls 12 und dem zweiten Masseanschluss 122 angeordnet sein, und auch dieser Position den zweiten Versorgungspfad B wahlweise leitfähig schalten oder sperren.

Das Schaltungsmodul 13 kann anstelle oder zusätzlich zu dem in der Fig. 2 dargestellten Feldeffekttransistor auch einen Bipolartransistor oder einen anderen Transistortyp umfassen. Ebenso könnte der Transistor 14 nicht als Bipolartransistor ausgebildet sein, sondern als Feldeffekttransistor.

Mit Bezug auf die in den Fig. 1 und Fig. 2 gezeigten Ausführungsbeispiele ist erläutert worden, dass das Steuergerät 1 das Ansteuersignal 1-1 in Abhängigkeit der am ersten Versorgungsspannungsanschluss 111 anliegenden Spannung erzeugt. Wie im allgemeinen Teil der Beschreibung bereits hervorgehoben ist, kann das Ansteuersignal 1-1 von dem Steuergerät 1 jedoch auch, zusätzlich oder alternativ zu der Erzeugung in Abhängigkeit der Spannung am ersten Versorgungsspannungsanschluss 111, in Abhängigkeit von einer fehlerhaften Versorgungsspannung und/oder in Abhängigkeit eines Fehlersignals erzeugt werden. Für diese Zwecke kann das Steuergerät 1 eine in den Figuren nicht dargestellte Auswerteeinheit umfassen, die eine derartige fehlerhafte Versorgungsspannung detektiert und/oder ein derartiges Fehlersignal empfängt.

Eine fehlerhafte Versorgungsspannung liegt beispielsweise vor, wenn das erste Steuermodul 11 nicht mehr an den ersten Masseanschluss 112 angeschlossen ist, das zweite Steuermodul 12 nicht mehr an den zweiten Masseanschluss 122 angeschlossen ist, ein Kurzschluss in einem ersten Teilnetz des Mehrspannungsbordnetzes und/oder in einem zweiten Teil des Mehrspannungsbordnetzes vorliegt, und/oder ein Potentialunterschied zwischen dem ersten Masseanschluss 112 und dem zweiten Masseanschluss 122 einen Schwellenwert von beispielsweise 1 V überschreitet.

Beispielsweise ist eine (in den Fig. nicht dargestellte) Überwachungseinheit zum Überwachen des Mehrspannungsbordnetzes vorgesehen. Die Überwachungseinheit kann ebenfalls in dem Gehäuse 17 des Steuergeräts 1 installiert sein. Alternativ ist die Überwachungseinheit außerhalb des Gehäuses 1 installiert. Beispielsweise führt die Überwachungseinheit des Mehrspannungsbordnetzes dem Steuergerät 1 das Fehlersignal zu. Die Überwachungseinheit erzeugt das Fehlersignal beispielsweise, wenn in dem Mehrspannungsbordnetz ein Zustand entsteht, der ein Abschalten der zweiten Versorgungsspannung in dem Steuergerät 1 erfordert oder bei dem ein Abschalten der zweiten Versorgungsspannung in dem Steuergerät 1 zweckmäßig ist. Beispielsweise generiert das Steuergerät 1 auf den Empfang des Fehlersignals hin das Ansteuersignal 1-1 derart, dass dieses das Schaltungsmodul 13 veranlasst, den zweiten Versorgungspfad B zu sperren.

Die in der Fig. 2 dargestellte erste Diode 116 und zweite Diode 117 könnten auch außerhalb des ersten Steuermoduls 11 angeordnet sein. Gleiches gilt sinngemäß für den zweiten ohmschen Widerstand 133. Dieser ohmsche Widerstand 133 könnte auch außerhalb des Schaltungsmoduls 13 angeordnet sein.

### Bezugszeichenliste / verwendete Abkürzungen

- 1: Steuergerät
- 1-1: Ansteuersignal
- 11: Erstes Steuermodul
- 111: Erster Versorgungsspannungsanschluss
- 1112: Steuersignalpfad
- 112: Erster Masseanschluss
- 113: Erste Steuersignalschnittstelle
- 114: Erster Versorgungseingang
- 115: Zweiter Versorgungsausgang
- 116: Erste Diode
- 117: Zweite Diode
- 118: Steuersignalsenderempfänger
- 12: Zweites Steuermodul
- 121: Zweiter Versorgungsspannungsanschluss
- 122: Zweiter Masseanschluss
- 123: Zweite Steuersignalschnittstelle
- 124: Zweiter Versorgungseingang
- 125: Zweiter Versorgungsausgang
- 13: Schaltungsmodul
- 131: Ansteuerbarer Schalter
- 131-1: Ansteuersignaleingang
- 131-2: Stromsignaleingang
- 131-3: Stromsignalausgang
- 133: Zweiter ohmscher Widerstand
- 14: Transistor
- 14-1: Transistorsteuereingang
- 14-2: Leistungssignaleingang
- 14-3: Leistungssignalausgang
- 15: Erster ohmsche Widerstand
- 17: Gehäuse
- A: Erster Versorgungspfad
- B: Zweiter Versorgungspfad
- C: Ansteuersignalpfad

## Patentansprüche

1. Steuergerät (1) für ein Mehrspannungsbordnetz eines Fahrzeugs, umfassend
- ein erstes Steuermodul (11), das über einen ersten Versorgungspfad (A) an einen ersten Versorgungsspannungsanschluss (111) des Steuergeräts (1) und/oder an einen ersten Masseanschluss (112) des Steuergeräts (1) angeschlossen ist, um mit Strom bei einer ersten Versorgungsspannung des Mehrspannungsbordnetzes versorgt zu werden; und
- ein zweites Steuermodul (12), das über einen zweiten Versorgungspfad (B) an einen zweiten Versorgungsspannungsanschluss (121) des Steuergeräts (1) und/oder an einen zweiten Masseanschluss (122) des Steuergeräts (1) angeschlossen ist, um mit Strom bei einer zweiten Versorgungsspannung des Mehrspannungsbordnetzes versorgt zu werden;
**dadurch gekennzeichnet, dass**
der zweite Versorgungspfad (B) ein Schaltungsmodul (13) enthält, das ausgebildet ist, den zweiten Versorgungspfad (B) in Abhängigkeit von einem Ansteuersignal (1-1) wahlweise zu sperren oder leitfähig zu schalten wobei das Steuergerät (1) ausgebildet ist, das Ansteuersignal (1-1) in Abhängigkeit von einer am ersten Versorgungsspannungsanschluss (111) anliegenden Spannung zu erzeugen,
wobei das erste Steuermodul (11) einen Steuersignalsenderempfänger (118) aufweist, der über wenigstens einen Steuersignalpfad (1112) an das zweite Steuermodul (12) gekoppelt ist, um dem zweiten Steuermodul (12) ein erstes Steuersignal bereitzustellen und/oder um von dem zweiten Steuermodul (12) ein zweites Steuersignal zu empfangen.

2. Steuergerät (1) nach Anspruch 1, **dadurch gekennzeichnet, dass** das Steuergerät (1) ausgebildet ist, das Ansteuersignal (1-1) in Abhängigkeit von einem Fehlersignal und/oder in Abhängigkeit von einer fehlerhaften Versorgungsspannung zu erzeugen, wobei die fehlerhafte Versorgungsspannung dann vorliegt, wenn wenigstens eines des Folgenden zutrifft:
- das erste Steuermodul (11) ist nicht mehr an den ersten Masseanschluss (112) angeschlossen;
- das zweite Steuermodul (12) ist nicht mehr an den zweiten Masseanschluss (122) angeschlossen;
- ein Kurzschluss in einem ersten Teilnetz des Mehrspannungsbordnetzes und/oder in einem zweiten Teilnetz des Mehrspannungsbordnetzes, wobei das erste Teilnetz bei der ersten Versorgungsspannung und das zweite Teilnetz bei der zweiten Versorgungsspannung betrieben wird; oder
- ein Potentialunterschied zwischen dem ersten Massenanschluss (112) und dem zweiten Masseanschluss (122) überschreitet einen Schwellenwert.

3. Steuergerät (1) nach einem der vorstehenden Ansprüche, **dadurch gekennzeichnet, dass** das Schaltungsmodul (13) ausgebildet ist, in Abhängigkeit von dem Ansteuersignal (1-1) wahlweise einen eingeschalteten Zustand oder einen ausgeschalteten Zustand einzunehmen, wobei im eingeschalteten Zustand der zweite Versorgungspfad (B) leitfähig ist, um die Stromversorgung bei der zweiten Versorgungsspannung sicherzustellen, und wobei im ausgeschalteten Zustand der zweite Versorgungspfad (B) gesperrt ist, um die Stromversorgung bei der zweiten Versorgungsspannung zu unterbinden.

4. Steuergerät (1) nach einem der vorstehenden Ansprüche, **dadurch gekennzeichnet, dass** das Schaltungsmodul (13) über einen Ansteuersignalpfad (C) an den ersten Versorgungsspannungsanschluss (111) angeschlossen ist, um das Ansteuersignal (1-1) zu empfangen.

5. Steuergerät (1) nach Anspruch 4, **dadurch gekennzeichnet, dass** der Ansteuersignalpfad (C) einen Transistor (14) enthält, der einen Transistorsteuereingang (14-1), einen Leistungssignaleingang (14-2) und einen Leistungssignalausgang (14-3) aufweist, wobei
- der Transistorsteuereingang (14-1) an den ersten Versorgungsspannungsanschluss (111) gekoppelt ist, und
- der Leistungssignaleingang (14-2) an den zweiten Versorgungsspannungsanschluss (121) und das Schaltungsmodul (13) gekoppelt ist, um dem Schaltungsmodul (13) das Ansteuersignal (1-1) zuzuführen.

6. Steuergerät (1) nach einem der vorstehenden Ansprüche, **dadurch gekennzeichnet, dass** das Schaltungsmodul (13) einen ansteuerbaren Schalter (131) mit einem Ansteuersignaleingang (131-1) zum Empfangen des Ansteuersignals (1-1) umfasst, wobei der ansteuerbare Schalter (131) ausgebildet ist, in Abhängigkeit von dem Ansteuersignal (1-1) geschaltet zu werden.

7. Steuergerät (1) nach Anspruch 6, **dadurch gekennzeichnet, dass** der ansteuerbare Schalter (131) einen Stromsignaleingang (131-2) und einen Stromsignalausgang (131-3) aufweist, wobei
- der Stromsignaleingang (131-1) auf den zweiten Versorgungsspannungsanschluss (121) geschaltet ist; oder
- Stromsignalausgang (131-3) auf den zweiten Masseanschluss (122) geschaltet ist.

8. Steuergerät (1) nach Anspruch 5 und nach Anspruch 6 oder 7, **dadurch gekennzeichnet, dass** das der Leistungssignaleingang (14-2) des Transistors (14) an den Ansteuersignaleingang (131-1) des ansteuerbaren Schalters (131) gekoppelt ist.

9. Steuergerät (1) nach Anspruch 6, 7 oder 8, **dadurch gekennzeichnet, dass** der Ansteuersignaleingang (131-1) an den zweiten Versorgungsspannungsanschluss (121) gekoppelt ist.

10. Steuergerät (1) nach einem der vorhergehenden Ansprüche, **dadurch gekennzeichnet, dass** das Steuergerät (1) ein Gehäuse (17) aufweist, in welchem das erste Steuermodul (11), das zweite Steuermodul (12) und das Schaltungsmodul (13) integriert sind.

11. Steuergerät (1) nach einem der vorstehenden Ansprüche, **dadurch gekennzeichnet, dass** der zweite Versorgungsspannung größer ist als die erste Versorgungsspannung.

12. Verfahren zum Betreiben eines Steuergeräts (1) für ein Mehrspannungsbordnetz eines Fahrzeugs, wobei das Steuergerät (1) aufweist:
- ein erstes Steuermodul (11), das über einen ersten Versorgungspfad (A) an einen ersten Versorgungsspannungsanschluss (111) des Steuergeräts (1) und/oder an einen ersten Masseanschluss (112) des Steuergeräts (1) angeschlossen ist, um mit Strom bei einer ersten Versorgungsspannung des Mehrspannungsbordnetzes versorgt zu werden; und
- ein zweites Steuermodul (12), das über einen zweiten Versorgungspfad (B) an einen zweiten Versorgungsspannungsanschluss (121) des Steuergeräts (1) und/oder an einen zweiten Masseanschluss (122) des Steuergeräts (1) angeschlossen ist, um mit Strom bei einer zweiten Versorgungsspannung des Mehrspannungsbordnetzes versorgt zu werden;
**dadurch gekennzeichnet, dass** das Verfahren umfasst:
- Steuern eines im zweiten Versorgungspfad (B) vorgesehenen Schaltungsmoduls (13) in Abhängigkeit von einem Ansteuersignal (1-1), um den zweiten Versorgungspfad (B) wahlweise zu sperren oder leitfähig zu schalten, wobei das Ansteuersignal (1-1) in Abhängigkeit von einer am ersten Versorgungsspannungsanschluss (111) anliegenden Spannung erzeugt wird,
wobei das erste Steuermodul (11) einen Steuersignalsenderempfänger (118) aufweist, der über wenigstens einen Steuersignalpfad (1112) an das zweite Steuermodul (12) gekoppelt ist und dem zweiten Steuermodul (12) ein erstes Steuersignal bereitstellt und/oder von dem zweiten Steuermodul (12) ein zweites Steuersignal empfängt.

## Claims

1. A controller (1) for a multi-voltage on-board power supply system in a vehicle, comprising:
- a first control module (11) which is connected via a first supply path (A) to a first supply voltage connection (111) of the controller (1) and/or to a first ground connection (112) of the controller (1) in order to be supplied with current at a first supply voltage of the multi-voltage on-board power supply system; and
- a second control module (12) which is connected via a second supply path (B) to a second supply voltage connection (121) of the controller (1) and/or to a second ground connection (122) of the controller (1) in order to be supplied with current at a second supply voltage of the multi-voltage on-board power supply system;
**characterized in that**
the second supply path (B) contains a switching module (13) which is designed to selectively block the second supply path (B) or switch the second supply path (B) in a conductive state depending on a control signal (1-1), wherein the controller (1) is designed to generate the control signal (1-1) depending on a voltage applied to the first supply voltage connection (111),
wherein the first control module (11) has a control signal transceiver (118) which is connected via at least one control signal path (1112) to the second control module (12) in order to supply the second control module (12) with a first control signal and/or to receive a second control signal from the second control module (12).

2. The controller (1) as claimed in claim 1, **characterized in that** the controller (1) is designed to generate the control signal (1-1) depending on a fault signal and/or depending on a defective supply voltage, wherein the defective supply voltage occurs if at least one of the following conditions prevails:
- the first control module (11) is no longer connected to the first ground connection (112);
- the second control module (12) is no longer connected to the second ground connection (122) ;
- a short circuit is present in a first subsystem of the multi-voltage on-board power supply system and/or in a second subsystem of the multi-voltage on-board power supply system, wherein the first subsystem is operated at the first supply voltage and the second subsystem is operated at the second supply voltage; or
- a difference in potential between the first ground connection (112) and the second ground connection (122) exceeds a threshold value.

3. The controller (1) as claimed in one of the preceding claims, **characterized in that** the switching module (13) is designed to assume either an activated state or a deactivated state depending on the control signal (1-1), wherein the second supply path (B) is conductive in the activated state in order to ensure the power supply at the second supply voltage, and wherein the second supply path (B) is blocked in the activated state in order to prevent the power supply at the second supply voltage.

4. The controller (1) as claimed in one of the preceding claims, **characterized in that** the switching module (13) is connected via a control signal path (C) to the first supply voltage connection (111) in order to receive the control signal (1-1).

5. The controller (1) as claimed in claim 4, **characterized in that** the control signal path (C) contains a transistor (14) which has a transistor control input (14-1), a power signal input (14-2) and a power signal output (14-3), wherein
- the transistor control input (14-1) is connected to the first supply voltage connection (111), and
- the power signal input (14-2) is connected to the second supply voltage connection (121) and the switching module (13) in order to feed the control signal (1-1) to the switching module (13) .

6. The controller (1) as claimed in one of the preceding claims, **characterized in that** the switching module (13) comprises a controllable switch (131) with a control signal input (131-1) to receive the control signal (1-1), wherein the controllable switch (131) is designed to be switched depending on the control signal (1-1).

7. The controller (1) as claimed in claim 6, **characterized in that** the controllable switch (131) has a current signal input (131-2) and a current signal output (131-3), wherein
- the current signal input (131-1) is connected to the second supply voltage connection (121); or
- the current signal output (131-3) is connected to the second ground connection (122).

8. The controller (1) as claimed in claim 5 and as claimed in claim 6 or 7, **characterized in that** the power signal input (14-2) of the transistor (14) is connected to the control signal input (131-1) of the controllable switch (131).

9. The controller (1) as claimed in claim 6, 7 or 8, **characterized in that** the control signal input (131-1) is connected to the second supply voltage connection (121).

10. The controller (1) as claimed in one of the preceding claims, **characterized in that** the controller (1) has a housing (17) in which the first control module (11), the second control module (12) and the switching module (13) are integrated.

11. The controller (1) as claimed in one of the preceding claims, **characterized in that** the second supply voltage is higher than the first supply voltage.

12. A method for operating a controller (1) for a multi-voltage on-board power supply system in a vehicle, wherein the controller (1) has:
- a first control module (11) which is connected via a first supply path (A) to a first supply voltage connection (111) of the controller (1) and/or to a first ground connection (112) of the controller (1) in order to be supplied with current at a first supply voltage of the multi-voltage on-board power supply system; and
- a second control module (12) which is connected via a second supply path (B) to a second supply voltage connection (121) of the controller (1) and/or to a second ground connection (122) of the controller (1) in order to be supplied with current at the second supply voltage of the multi-voltage on-board power supply system;
**characterized in that** the method comprises:
- controlling a switching module (13) provided in the second supply path (B) depending on a control signal (1-1) in order to selectively block the second supply path (B) or switch the second supply path (B) in a conductive state, wherein the control signal (1-1) is generated depending on a voltage applied to the first supply voltage connection (111),
wherein the first control module (11) has a control signal transceiver (118) which is connected via at least one control signal path (1112) to the second control module (12) and supplies the second control module (12) with a first control signal and/or receives a second control signal from the second control module (12).

## Revendications

1. Appareil de commande (1) pour un réseau de bord multitension d'un véhicule, comprenant
- un premier module de commande (11), qui est raccordé à un premier raccord de tension d'alimentation (111) de l'appareil de commande (1) et/ou à un premier raccord de masse (112) de l'appareil de commande (1) par l'intermédiaire d'un premier trajet d'alimentation (A) pour être alimenté en courant pour une première tension d'alimentation du réseau de bord multitension ; et
- un deuxième module de commande (12), qui est raccordé à un deuxième raccord de tension d'alimentation (121) de l'appareil de commande (1) et/ou à un deuxième raccord de masse (122) de l'appareil de commande (1) par l'intermédiaire d'un deuxième trajet d'alimentation (B) pour être alimenté en courant pour une deuxième tension d'alimentation du réseau de bord multitension ;
**caractérisé en ce que**
le deuxième trajet d'alimentation (B) contient un module de circuit (13), qui est réalisé pour au choix fermer ou commuter de manière conductrice le deuxième trajet d'alimentation (B) en fonction d'un signal de pilotage (1-1), dans lequel l'appareil de commande (1) est réalisé pour générer le signal de pilotage (1-1) en fonction d'une tension appliquée sur le premier raccord de tension d'alimentation (111),
dans lequel le premier module de commande (11) présente un récepteur-émetteur de signaux de commande (118), qui est couplé par l'intermédiaire d'au moins un trajet de signaux de commande (1112) au deuxième module de commande (12) pour fournir au deuxième module de commande (12) un premier signal de commande et/ou pour recevoir un deuxième signal de commande du deuxième module de commande (12).

2. Appareil de commande (1) selon la revendication 1, **caractérisé en ce que** l'appareil de commande (1) est réalisé pour générer le signal de pilotage (1 - 1) en fonction d'un signal d'erreur et/ou en fonction d'une tension d'alimentation défectueuse, dans lequel la tension d'alimentation défectueuse est présente quand au moins un des critères suivants s'applique :
- le premier module de commande (11) n'est plus raccordé au premier raccord de masse (112) ;
- le deuxième module de commande (12) n'est plus raccordé au deuxième raccord de masse (122) ;
- un court-circuit est effectué dans un premier réseau partiel du réseau de bord multitension et/ou dans un deuxième réseau partiel du réseau de bord multitension, dans lequel le premier réseau partiel fonctionne lors de la première tension d'alimentation et le deuxième réseau partiel fonctionne lors de la deuxième tension d'alimentation ; ou
- une différence de potentiel entre le premier raccord de masse (112) et le deuxième raccord de masse (122) dépasse une valeur de seuil.

3. Appareil de commande (1) selon l'une quelconque des revendications précédentes, **caractérisé en ce que** le module de circuit (13) est réalisé pour adopter en fonction du signal de pilotage (1-1) au choix un état activé ou un état désactivé, dans lequel dans l'état activé, le deuxième trajet d'alimentation (B) est conducteur pour assurer l'alimentation en courant dans le cas de la deuxième tension d'alimentation et dans lequel dans l'état désactivé, le deuxième trajet d'alimentation (B) est fermé pour empêcher l'alimentation en courant dans le cas de la deuxième tension d'alimentation.

4. Appareil de commande (1) selon l'une quelconque des revendications précédentes, **caractérisé en ce que** le module de circuit (13) est raccordé au premier raccord de tension d'alimentation (111) par l'intermédiaire d'un trajet de signal de pilotage (C) pour recevoir le signal de pilotage (1-1).

5. Appareil de commande (1) selon la revendication 4, **caractérisé en ce que** le trajet de signal de pilotage (C) contient un transistor (14), qui présente une entrée de commande de transistor (14-1), une entrée de signal de puissance (14-2) et une sortie de signal de puissance (14-3), dans lequel
- l'entrée de commande de transistor (14-1) est couplée au premier raccord de tension d'alimentation (111), et
- l'entrée de signal de puissance (14-2) est couplée au deuxième raccord de tension d'alimentation (121) et au module de circuit (13) pour amener au module de circuit (13) le signal de pilotage (1-1).

6. Appareil de commande (1) selon l'une quelconque des revendications précédentes, **caractérisé en ce que** le module de circuit (13) comprend un commutateur (131) pouvant être piloté avec une entrée de signal de pilotage (131-1) pour recevoir le signal de pilotage (1-1), dans lequel le commutateur (131) pouvant être piloté est réalisé pour être commuté en fonction du signal de pilotage (1-1).

7. Appareil de commande (1) selon la revendication 6, **caractérisé en ce que** le commutateur (131) pouvant être piloté présente une entrée de signaux de courant (131-2) et une sortie de signaux de courant (131-3), dans lequel
- l'entrée de signal de courant (131-1) est commutée sur le deuxième raccord de tension d'alimentation (121) ; ou
- la sortie de signaux de courant (131-3) est commutée sur le deuxième raccord de masse (122).

8. Appareil de commande (1) selon la revendication 5 ou selon la revendication 6 ou 7, **caractérisé en ce que** l'entrée de signaux de puissance (14-2) du transistor (14) est couplée à l'entrée de signaux de pilotage (131-1) du commutateur (131) pouvant être piloté.

9. Appareil de commande (1) selon la revendication 6, 7 ou 8, **caractérisé en ce que** l'entrée de signaux de pilotage (131-1) est couplée au deuxième raccord de tension d'alimentation (121).

10. Appareil de commande (1) selon l'une quelconque des revendications précédentes, **caractérisé en ce que** l'appareil de commande (1) présente un boîtier (17), dans lequel le premier module de commande (11), le deuxième module de commande (12) et le module de circuit (13) sont intégrés.

11. Appareil de commande (1) selon l'une quelconque des revendications précédentes, **caractérisé en ce que** la deuxième tension d'alimentation est supérieure à la première tension d'alimentation.

12. Procédé pour faire fonctionner un appareil de commande (1) pour un réseau de bord multitension d'un véhicule, dans lequel l'appareil de commande (1) présente :
- un premier module de commande (11), qui est raccordé à un premier raccord de tension d'alimentation (111) de l'appareil de commande (1) et/ou à un premier raccord de masse (112) de l'appareil de commande (1) par l'intermédiaire d'un premier trajet d'alimentation (A) pour être alimenté en courant pour une première tension d'alimentation du réseau de bord multitension ; et
- un deuxième module de commande (12), qui est raccordé à un deuxième raccord de tension d'alimentation (121) de l'appareil de commande (1) et/ou à un deuxième raccord de masse (122) de l'appareil de commande (1) par l'intermédiaire d'un deuxième trajet d'alimentation (B) pour être alimenté en courant pour une deuxième tension d'alimentation du réseau de bord multitension ;
**caractérisé en ce que** le procédé comprend :
- la commande d'un module de circuit (13) prévu dans le deuxième trajet d'alimentation (B) en fonction d'un signal de pilotage (1-1) pour au choix fermer ou commuter de manière conductrice le deuxième trajet d'alimentation (B), dans lequel le signal de pilotage (1-1) est généré en fonction d'une tension appliquée sur le premier raccord de tension d'alimentation (111),
dans lequel le premier module de commande (11) présente un récepteur-émetteur de signaux de commande (118), qui est couplé au deuxième module de commande (12) par l'intermédiaire d'au moins un trajet de signaux de commande (1112) et fournit un premier signal de commande au deuxième module de commande (12) et/ou reçoit un deuxième signal de commande du deuxième module de commande (12).
